# EUROPÄISCHE PATENTSCHRIFT

(11) **EP 0 591 260 B1**
(45) Veröffentlichungstag und Bekanntmachung des Hinweises auf die Patenterteilung: **10.05.1995**
(21) Anmeldenummer: 92911637.4
(22) Anmeldetag: 17.06.1992
(51) Int. Cl.: H03D 9/06, H03B 5/18

(54) **ANORDNUNG FÜR EINEN MODULATOR**
ARRANGEMENT FOR A MODULATOR
AGENCEMENT POUR MODULATEUR

(30) Priorität: 26.06.1991 DE 4121027
(43) Veröffentlichungstag der Anmeldung: 13.04.1994
(73) Patentinhaber: Deutsche Thomson-Brandt GmbH, 78003 Villingen-Schwenningen (DE)
(72) Erfinder: MAIER, Gerhard, D-78083 Dauchingen (DE); FISCHER, Bertram, D-78652 Deisslingen (DE); LANGE, Joachim, D-78048 Villingen-Schwenningen (DE)
(86) Internationale Anmeldenummer: EP9201371
(87) Internationale Veröffentlichungsnummer: WO9300738

(56) Entgegenhaltungen:
- DE-A- 3 328 659
- GB-A- 2 118 392
- PATENT ABSTRACTS OF JAPAN, Bd. 13, Nr. 348 (E-799)4. August 1989;& JP-A-1106630

## Beschreibung

Die vorliegende Erfindung betrifft eine Schaltungsplatine mit einem Oszillator und einem Modulator oder Demodulator.

Derartige Anordnungen werden z.B. in Videorecordern verwendet, um ein von einem Magnetband abgetastetes video- und tonfrequentes Signal in eine Frequenz umzusetzen, welche von den Hochfrequenzkreisen in einem Fernsehempfänger aufbereitet werden können, um so ein reproduzierbares Bild auf dem Bildschirm des Fernsehempfängers wiedergeben zu können. Der Modulator besteht aus zwei Dioden, an welche einerseits eine von einem Oszillator erzeugte Trägerfrequenz von einigen 100 MHz und andererseits das video- und tonfrequente Signal angelegt werden. Zur Vermeidung von unerwünschten Verkopplungen durch Störstrahlung des Oszillators muß dieser gut abgeschirmt werden, damit die Oszillatorfrequenz nicht in die zahlreichen induktiven Elemente, wie Luftspulen und Übertrager einstreuen kann. Zur Auskopplung der Oszillatorfrequenz wird üblicherweise ein Ferritübertrager eingesetzt. Der Übertrager muß exakt symmetrisch abgeglichen werden, damit er sekundärseitige symmetrische Oszillatorschwingungen in den Modulatorkreis einkoppelt. Die Oszillatorfrequenz muß genau abgeglichen werden. Die Abschirmung des Oszillators erfolgt üblicherweise mit Hilfe von Abschirmkappen, die beiderseits der Trägerplatine angeordnet sind. Das bedeutet neben der Abgleicharbeit auch noch einen hohen mechanischen Aufwand.

Es ist z.B. ein Tuner für Satelliten-Rundfunkempfang bekannt ( JP 1106630 v.24.04.89). Dieser ist in mikrostrip-Technik aufgebaut, d.h. die Schwingkreise sind in Gestalt von gedruckten Leitern ausgeführt, in Verbindung mit einem auf der anderen Seite einer Platine angeordneten Kapazitätsbelag.

Auch ist bekannt, einen spannungsgesteuerten Oszillator in mikrostrip-Technik derart aufzubauen (GB 118 392 A). Auch hier dient der Belag als Kapazität für den Schwingkreis und nicht zur Abschirmung der Oszillatorschwingungen gegenüber einem Modulator.

Der Erfindung liegt die Aufgabe zugrunde, eine Modulatoranordnung mit großem Durchstimmbereich der Modulationsfrequenz zu schaffen, mit guter Konstanz des Modulationsgrades unter Vermeidung von abzugleichenden Elementen, wodurch die Fertigung einer solchen Anordnung automatisiert werden kann. Diese Aufgabe wird dadurch gelöst, daß der Schwingkreis des Oszillators in gedruckter Schaltungstechnik mit einer Induktivität in Verbindung mit einer Kapazitätsdiode ausgebildet ist, wobei die gedruckte Induktivität mit einer ebenso gedruckten Induktivität des Modulators gekoppelt ist, und daß im Bereich des Oszillators und des Mischers auf der gegenüberliegenden Seite der Schaltungsplatine eine auf Bezugspotential liegende leitende Fläche zwecks Abschirmung der von dem Oszillator erzeugten Schwingungen angeordnet ist, welche über Durchkontaktpunkte mit im Oszillator- und Modulatorbereich auf der anderen Seite der Schaltungsplatine angeordneten leitenden Flächen verbunden ist und so eine Einkopplung von Oszillatorschwingungen auf den Modulatorausgang verhindert wird.

Nachfolgend wird ein Ausführungsbeispiel der Erfindung mit Hilfe der Zeichnung beschrieben.
Figur 1 zeigt die Anordnung in einer Schaltung
Figur 2 zeigt ein Beispiel für einen Video-Ton-Modulator
Figur 3 zeigt ein Beispiel für einen Video-Ton-Demodulator

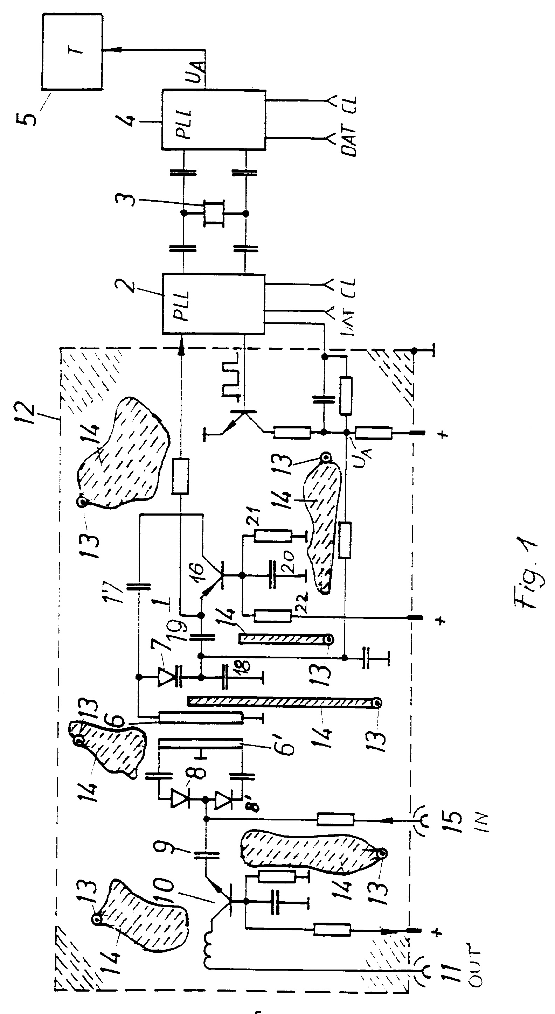

In Figur 1 wird die Erfindung an dem Beispiel eines Video-Ton-Modulators beschrieben. Die Schaltung ist auf einer doppelseitig kaschierten Schaltungsplatte angeordnet. Der insgesamt mit 1 bezeichnete Oszillator weist einen Transistor 16 auf, dessen Kollektor über einen Rückkopplungskonbensator 17 mit einem Oszillatorschwingkreis verbunden ist, welcher aus einer in gedruckter Schaltungstechnik ausgebildeten Induktivität 6 und einer Kapazitätsdiode 7 in Serie zu einem Kondensator 18 besteht. Der Verbindungspunkt zwischen der Kapazitätsdiode 7 und dem Kondensator 18 ist über einen Kondensator 19 mit dem Emitter des Transistors 16 verbunden, dessen Basis über die Parallelschaltung eines Kondensators 20 und eines Widerstandes 21 auf das Bezugspotential geschaltet ist. Über den Widerstand 22 wird die Basisvorspannung an den Transistor 16 gelegt. Die von einer PLL-Schaltung 2 erzeugte Abstimmspannung UA wird über den Widerstand 23 der Kapazitätsdiode 7 zugeführt. Die Frequenz des Oszillators 1 wird durch einen Quarz 3 stabil erzeugt und kann durch Dateneingabe bei DAT eingestellt werden. Der Quarz 3 dient gleichzeitig als Referenz für eine weitere PLL-Schaltung 4, die zur Erzeugung der Abstimmspannung UA für den Tuner 5 des Videorecorders herangezogen wird. Die von dem Oszillator 1 erzeugte Frequenz wird über eine gedruckte Induktivität 6′ ausgekoppelt. Die Induktivität 6 bildet zusammen mit der Kapazitätsdiode 7 und dem Kondensator 18 das frequenzbestimmende Glied des Oszillators 1. Da die Auskopplung in gedruckter Schaltungstechnik sehr präzise herstellbar ist, kann auch ein großer Frequenzbereich von 600 bis 850 MHz überstrichen werden und ist deshalb für eine Großserienfertigung ideal geeignet. Auch die Symmetrierung ist durch die Ausbildung in gedruckter Schaltungstechnik präzise vorgebbar, so daß ein Abgleich entfallen kann. Das Video- sowie das Ton-ZF-Eingangssignal (4,5 MHz bis 6,5 MHz) wird über die Buchse 15 den beiden Modulatordioden 8, 8′ zugeführt. Das umgesetzte Signal wird über einen Kondensator 9 und eine Trennstufe 10 auf den Ausgang 11 gegeben, von welchem es als Antennensignal für einen Fernsehempfänger abnehmbar ist.

Die Abschirmung des Oszillators 1 erfolgt in besonders vorteilhafter Weise auf folgende Art. Auf der den Leiterbahnen mit den Bauteilen versehenen gegenüberliegenden Seite der Schaltungsplatine ist eine auf Bezugspotential liegende elektrisch leitende Fläche 12 angebracht, die durch die gestrichelte Linie umfaßt wird. Die in den Ecken der umrandeten Fläche gezeigte Schraffierung soll die elektrisch leitende Fläche 12 charakterisieren. Im Bereich dieser Fläche 12 besitzt die Schaltungsplatine mehrere Durchkontaktierungspunkte 13, die mit symbolisch angedeuteten Leiterbahnen 14 auf der gegenüberliegenden Seite der Platine elektrisch verbunden sind, welche in die Leiterbahnen der gedruckten Schaltung eingebettet sind. Da wegen der Anwendung einer gedruckten Schaltungstechnik keine Luftspulen und kein Transformator (Übertrager) verwendet wird, ergibt sich durch die leitende Fläche 12 eine sehr gute Abschirmung gegen das Magnetfeld der Oszillatorschwinungen. Das Streufeld wird durch die Leiterbahnen 14 und die leitende Fläche 12 kurzgeschlossen.

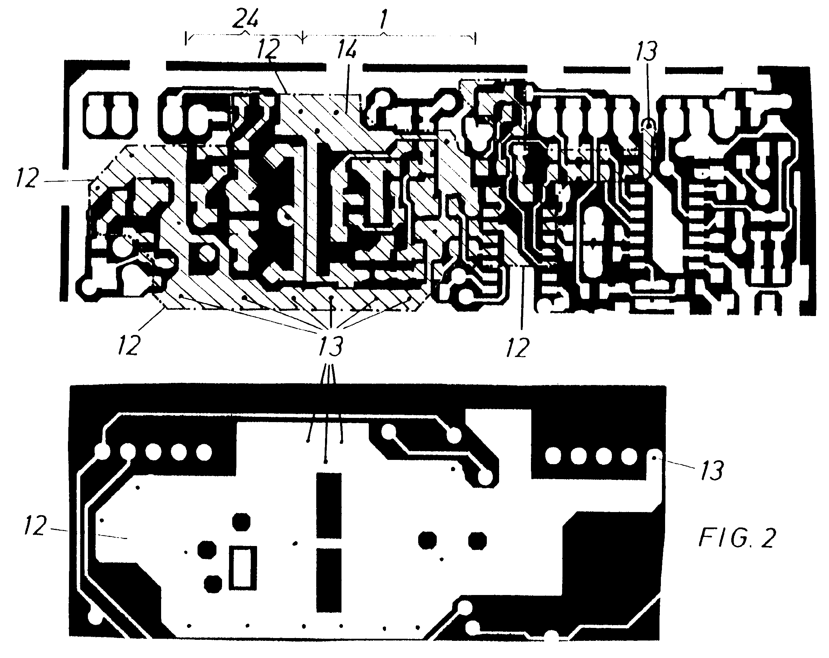

Im oberen Teil der Figur 2 ist die Anordnung der gedruckten Modulator- und Oszillatorschaltung (24, 1) dargestellt. Die auf der anderen Seite der Platine angeordnete elektrisch leitende Fläche ist durch die Umrandung 12 umschrieben. Es sind die Durchkontaktierungspunkte 13 zu erkennen, welche eine Durchkontaktierung der Oberseite der Platine mit ihrer Unterseite erlauben. Diejenigen leitenden Flächen, die mit der Unterseite kontaktiert sind, sind schraffiert dargestellt. So ergeben sich auf der Oberseite die mit Bezugspotential verbundenen Bereiche. Im unteren Teil der Figur 2 ist die Fläche dargestellt, die auf der unteren Seite der Platine angeordnet ist, wie sie von oben durch die Platine hindurch gesehen würde. Wenn man diese Fläche unter den oberen Teil der Figur 2 schiebt, decken sich die Punkte 13 der Fläche 12 mit den Punkten 13 in der gedruckten Schaltung.

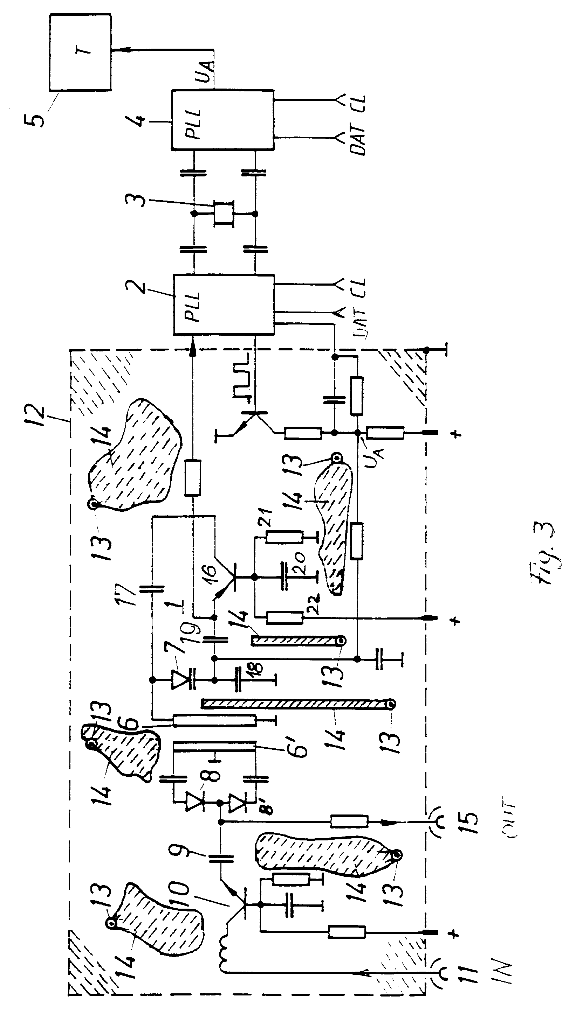

In Figur 3 ist die Anordnung für einen Video-Ton-Demodulator dargestellt. Das trägerfrequente modulierte Signal wird hier der Eingang 11 zugeführt und über den Verstärker 10 an die Demodulatordioden 8, 8′ gelegt. Am Ausgang 15 kann das demodulierte Signal abgenommen werden.

## Patentansprüche

1. Schaltungsplatine mit einem Oszillator und einem Modulator oder Demodulator, wobei der Schwingkreis des Oszillators in gedruckter Schaltungstechnik mit einer gedruckten Induktivität in Verbindung mit einer Kapazitätsdiode ausgebildet ist,
**dadurch gekennzeichnet,** daß die Induktivität (6) des Oszillatorschwingkreises mit einer gedruckten Induktivität (6′) des Modulators (8, 8′) gekoppelt ist, und daß zwecks Abschirmung der von dem Oszillator (1) erzeugten Schwingungen im Bereich des Oszillators (1) und des Modulators oder Demodulators (8, 8′, 6′) auf der gegenüberliegenden Seite der Schaltungsplatine eine auf Bezugspotential liegende leitende Fläche (12) angeordnet ist, welche mit im Oszillatorbereich (1) sowie im Modulatorbereich bzw. Demodulatorbereich (24) auf der anderen Seite der Schaltungsplatine angeordneten leitenden Flächen (14) elektrisch leitend verbunden ist und so eine Einkopplung von Oszillatorschwingungen auf den Modulatorausgang verhindert wird.

2. Schaltungsplatine nach Anspruch 1, **dadurch gekennzeichnet,** daß die elektrisch leitende Verbindung zwischen der Schicht (12) und den Schichten (14) mittels einer oder mehrerer Durchkontaktierungen über Durchkontaktierungspunkte (13) erfolgt.

3. Schaltungsplatine nach Anspruch 1 oder 2, **dadurch gekennzeichnet,** daß sie für einen Video-Ton-Modulatorin einem Videorekorder vorgesehen ist.

4. Schaltungsplatine nach Anspruch 1 oder 2, **dadurch gekennzeichnet,** daß sie für einen Video-Ton-Modulator in einem Stand-alone-Dekoder vorgesehen ist.

## Claims

1. A circuit board with an oscillator and a modulator or demodulator, wherein the oscillating circuit of the oscillator is constructed in accordance with printed circuitry technology with a printed inductance in connection with a capacitance diode, characterised in that the inductance (6) of the oscillator oscillating circuit is coupled to a printed inductance (6′) of the modulator (8, 8′), and that for the screening of the oscillations generated by the oscillator (1) in the region of the oscillator (1) and the modulator or demodulator (8, 8′, 6′) on the opposite side of the circuit board there is arranged a conductive surface (12) which carries reference potential and which is electrically conductively connected to conductive surfaces (14) arranged in the region of the oscillator (1) and in the region of the modulator or demodulator (24) on the other side of the circuit board, whereby the input-coupling of oscillator oscillations to the modulator output is prevented.

2. A circuit board as claimed in Claim 1, characterised in that the electrically conductive connection between the layer (12) and the layers (14) is established by means of one or more through-contacts via through-contact points (13).

3. A circuit board as claimed in Claim 1 or 2, characterised in that it is provided for a video-sound modulator in a video recorder.

4. A circuit board as claimed in Claim 1 or 2, characterised in that it is provided for a video-sound modulator in a stand-alone decoder.

## Revendications

1. Carte à circuits imprimés comportant un oscillateur et un modulateur ou démodulateur, le circuit oscillant dudit oscillateur étant conçu en technique de circuit imprimé avec une inductance imprimée reliée à une diode varicap,
**caractérisée en ce** que l'inductance (6) du circuit oscillant de l'oscillateur est couplée à une inductance imprimée (6′) du modulateur (8, 8′) et que, pour écranter les oscillations générées par l'oscillateur (1) dans la zone de l'oscillateur (1) et du modulateur ou démodulateur (8, 8′, 6′), une surface électroconductrice (12) connectée au potentiel de référence est disposée sur la face opposée de la carte, ladite surface étant connectée électriquement à une surface conductrice (14) disposée sur l'autre face de la carte, dans la zone de l'oscillateur (1) ainsi que dans la zone du modulateur ou du démodulateur (24) et qu'une interférence des oscillations de l'oscillateur sur la sortie du modulateur est ainsi empêchée.

2. Carte à circuits imprimés selon la revendication 1, **caractérisée en ce** que la liaison électrique entre la surface (12) et la surface (14) est réalisée par une ou plusieurs connexions traversantes à l'aide de points d'interconnexion (13).

3. Carte à circuits imprimés selon la revendication 1 ou 2, **caractérisée en ce** qu'elle est prévue pour un modulateur vidéo-son dans un magnétoscope.

4. Carte à circuits imprimés selon la revendication 1 ou 2, **caractérisée en ce** qu'elle est prévue pour un modulateur vidéo-son dans un décodeur autonome.
